# EUROPÄISCHE PATENTSCHRIFT

(11) **EP 3 721 461 B1**
(45) Veröffentlichungstag und Bekanntmachung des Hinweises auf die Patenterteilung: **05.03.2025**
(21) Anmeldenummer: 19700548.1
(22) Anmeldetag: 03.01.2019
(51) Int. Cl.: H01F 38/30, G01R 15/18

(54) **STROMWANDLER**
CURRENT CONVERTER
TRANSFORMATEUR DE COURANT

(30) Priorität: 30.01.2018 DE 102018201359
(43) Veröffentlichungstag der Anmeldung: 14.10.2020
(73) Patentinhaber: HSP Hochspannungsgeräte GmbH, 53842 Troisdorf (DE)
(72) Erfinder: HOPPE, Lars, 96050 Bamberg (DE)
(74) Vertreter: Betten & Resch
(86) Internationale Anmeldenummer: PCT/EP2019/050074
(87) Internationale Veröffentlichungsnummer: WO 2019/149463

(56) Entgegenhaltungen:
- EP-A1- 2 980 597
- DE-A1- 102015 214 043
- US-A1- 2015 331 015
- US-B1- 6 984 979

## Beschreibung

Die Erfindung betrifft einen Stromwandler zur Überwachung von Stromnetzen mit Gleich- und Wechselströmen beziehungsweise Mischströmen sowie ein Verfahren zum Messen von Strömen mit einem derartigen Stromwandler.

Insbesondere betrifft die Erfindung Stromwandler für Hoch- und Mittelspannungsnetze. In Wechselstromnetzen werden in der Regel induktive Stromwandler eingesetzt, die auf dem Transformatorprinzip basieren. Mit diesen induktiven Stromwandlern können jedoch keine Gleichströme oder Gleichstromanteile von Mischströmen erfasst werden. Die Erfassung von Gleichströmen und Gleichstromanteilen ist insbesondere zur Überwachung von Stromnetzen mit Hochspannungs-Gleichstrom-Übertragungsstrecken erforderlich. Derartige Stromnetze gewinnen zunehmend an Bedeutung, insbesondere um elektrische Energie über große Entfernungen verlustarm zu transportieren.

US 2015/0331015 A1 offenbart eine kontaktlose Strommessvorrichtung vom Flux-Gate-Typ zum Messen eines Stroms durch Erfassen eines elektromagnetischen Feldes um einen leitenden Draht, in dem der Strom fließt. Die Strommessvorrichtung kann eine Gleichstromkomponente des Stroms durch eine Änderung eines oszillierenden Signals zum Magnetisieren zweier Kerne mit entgegengesetzten Polaritäten und eine Wechselstromkomponente des Stroms unter Verwendung eines weiteren Kerns erfassen.

Der Erfindung liegt die Aufgabe zugrunde, einen Stromwandler und ein Verfahren zum Messen von Strömen anzugeben, die insbesondere hinsichtlich der Erfassung von Wechsel- und Gleichströmen verbessert sind.

Die Aufgabe wird erfindungsgemäß durch einen Stromwandler mit den Merkmalen des Anspruchs 1 und ein Verfahren mit den Merkmalen des Anspruchs 9 gelöst.

Vorteilhafte Ausgestaltungen der Erfindung sind Gegenstand der Unteransprüche.

Ein erfindungsgemäßer Stromwandler ermöglicht die Erfassung sowohl von Wechselströmen beziehungsweise Wechselstromanteilen von Mischströmen als auch von Gleichströmen beziehungsweise Gleichstromanteilen von Mischströmen.

Zur Erfassung von Wechselströmen und Wechselstromanteilen von Mischströmen weist der Stromwandler insbesondere einen induktiven Wechselstromsensor auf, der auf dem Transformatorprinzip basiert: ein durch den Primärleiter fließender Wechselstrom oder Wechselstromanteil erzeugt ein sich zeitlich änderndes Primärmagnetfeld, das in der Sekundärspule eine Sekundärspannung und einen Sekundärstrom induziert, über die der durch den Primärleiter fließende Wechselstrom oder Wechselstromanteil erfasst werden kann.

Zusätzlich weist der Stromwandler einen Kompensationsstromsensor auf, mit dem insbesondere Gleichströme und Gleichstromanteile von Mischströmen erfasst werden können: ein durch den Primärleiter fließender Primärstrom erzeugt in der Umgebung des Primärleiters ein Primärmagnetfeld; in der Kompensationsspule wird ein Kompensationsstrom eingestellt, der ein Kompensationsmagnetfeld erzeugt, das das Primärmagnetfeld am Ort des Magnetometers kompensiert, und über den der Primärstrom erfasst wird.

Ein erfindungsgemäßer Stromwandler kann daher insbesondere vorteilhaft zur Überwachung von Stromnetzen mit Gleich- und Wechselströmen beziehungsweise Mischströmen eingesetzt werden, in denen sonst separate Gleich- und Wechselstromwandler eingesetzt werden müssten. Dabei wird die Kompensationsspule des Kompensationsstromsensors in demselben Gehäuse wie die wenigstens eine Sekundärspule des induktiven Wechselstromsensors eingebaut, so dass für den Bau eines erfindungsgemäßen Stromwandlers eine Gehäusebauweise verwendet werden kann, die von herkömmlichen induktiven Wechselstromwandlern bekannt ist und sich dort bewährt hat. Ein erfindungsgemäßer Stromwandler kann separat ausgeführt oder Bestandteil eines kombinierten Strom- und Spannungswandlers sein.

Eine Ausgestaltung der Erfindung sieht vor, dass der induktive Wechselstromsensor wenigstens einen Messkern und wenigstens einen Schutzkern aufweist. Unter einem Messkern beziehungsweise Schutzkern wird ein weichmagnetischer Magnetkern einer Sekundärspule verstanden. Mess- und Schutzkerne unterscheiden sich nicht prinzipiell voneinander, sondern nur durch ihre Auslegung für Mess- beziehungsweise Schutzzwecke. Die Verwendung von Messkernen und Schutzkernen ermöglicht eine Bündelung des von dem Primärleiter erzeugten Primärmagnetfeldes an den Orten dieser Kerne.

Die Erfindung sieht vor, dass das Magnetometer ein Fluxgate-Magnetometer ist. Insbesondere weist das Fluxgate-Magnetometer zwei in dem Gehäuse angeordnete, ringförmig um den Primärleiter verlaufende Kompensationskerne und eine gegensinnig um die beiden Kompensationskerne gewickelte Erregerwicklung auf Fluxgate-Magnetometer haben gegenüber anderen Magnetometern, beispielsweise gegenüber Hall-Sensoren den Vorteil, Signale mit keinem oder einem nur geringen Offset zu liefern. Ferner können sie im Wesentlichen aus denselben Komponenten und Materialien wie induktive Wechselstromsensoren gefertigt werden, so dass keine gesonderten aufwändigen Schutzvorrichtungen zum Schutz ihrer Komponenten in dem Gehäuse vorgesehen werden müssen. Fluxgate-Magnetometer mit zwei Kompensationskernen, auf die gegensinnig eine Erregerwicklung gewickelt ist, haben ferner den Vorteil, dass sich die Rückwirkungen der Kompensationskerne auf den Primärleiter weitgehend gegenseitig kompensieren.

Außerdem ist vorgesehen, dass das Fluxgate-Magnetometer außer den beiden Kompensationskernen einen in dem Gehäuse angeordneten, ringförmig um den Primärleiter verlaufenden Zusatzkern und eine Zusatzsekundärwicklung aufweist und die Zusatzsekundärwicklung und die Kompensationsspule um den Zusatzkern gewickelt sind. Durch den Zusatzkern und die Zusatzsekundärwicklung kann der Kompensationsstromsensor auch zur Erfassung von Wechselströmen beziehungsweise Wechselstromanteilen verwendet werden, beispielsweise zur Erfassung von Wechselströmen beziehungsweise Wechselstromanteilen, für deren Messung der induktive Wechselstromsensor nicht ausgelegt ist und die auch mittels der beiden Kompensationskerne nicht erfasst werden.

In einer nicht beanspruchten Ausgestaltung kann der Kompensationsstromsensor statt eines Fluxgate-Magnetometers ein Magnetometer mit einem Hall-Sensor aufweisen. Beispielsweise kann der Kompensationsstromsensor einen in dem Gehäuse angeordneten, ringförmig um den Primärleiter verlaufenden Magnetkern aufweisen, um den die Kompensationsspule gewickelt ist und der einen Luftspalt aufweist, in dem der Hall-Sensor angeordnet ist. Dies ermöglicht, mit dem Hall-Sensor die Summe des von dem Primärleiter erzeugten Primärmagnetfeldes und des von der Kompensationsspule erzeugten Kompensationsmagnetfeldes am Ort des Hall-Sensors zu erfassen und den in der Kompensationsspule fließenden Kompensationsstrom so einzustellen, dass diese Summe verschwindet. Durch die Anordnung des Hall-Sensors in dem Luftspalt eines mit der Kompensationsspule umwickelten Magnetkerns wird das Magnetfeld vorteilhaft am Ort des Hall-Sensors gebündelt.

Eine weitere Ausgestaltung der Erfindung sieht ein in dem Gehäuse angeordnetes Wicklungsgehäuse vor, in dem die wenigstens eine Sekundärspule und die Kompensationsspule angeordnet sind. Durch das Wicklungsgehäuse, das auch als Kernschale bezeichnet wird, kann ein elektrisches Potential in der Umgebung der Sekundär- und Kompensationsspulen festgelegt werden, beispielsweise indem das Wicklungsgehäuse geerdet wird.

Das Wicklungsgehäuse ist vorzugsweise gegenüber dem Gehäuse elektrisch isoliert. Beispielsweise ist das Gehäuse mit einem Isoliergas oder einer Isolierflüssigkeit oder einer Isoliermasse befüllt. Dadurch wird verhindert, dass eine an dem Gehäuse anliegende elektrische Spannung, insbesondere eine Hochspannung, auf das Wicklungsgehäuse übertragen wird.

Weitere Ausgestaltungen der Erfindung sehen vor, dass der induktive Wechselstromsensor eine erste Messschaltung aufweist, die außerhalb des Gehäuses angeordnet ist und mit jeder Sekundärspule elektrisch verbunden ist, und/oder dass der Kompensationsstromsensor eine zweite Messschaltung aufweist, die außerhalb des Gehäuses angeordnet ist und mit der Kompensationsspule und dem Magnetometer elektrisch verbunden ist. Diese Ausgestaltungen der Erfindung sehen die Anordnung der Messschaltungen des Stromwandlers außerhalb des Gehäuses vor. Dadurch können die Messschaltungen vorteilhaft an geschützten und leicht zugänglichen Orten, beispielsweise in einem Schaltschrank, angeordnet werden.

Eine weitere Ausgestaltung der Erfindung sieht vor, dass der Kompensationsstromsensor deaktivierbar ist, wobei insbesondere die Kompensationsspule kurzschließbar ist. Diese Ausgestaltung der Erfindung berücksichtigt, dass ein Kompensationsstromsensor elektrische Energie zur Versorgung der Kompensationsspule und des Magnetometers benötigt. Daher ist es vorteilhaft, den Kompensationsstromsensor deaktivierbar zu gestalten, um ihn nur bedarfsweise aktivieren zu können, insbesondere wenn ein Gleichstrom oder Gleichstromanteil erfasst werden soll. Dadurch können der Energieverbrauch und die Betriebskosten des Stromwandlers vorteilhaft gesenkt werden. Ferner können die Anschaffungskosten beziehungsweise Erstanschaffungskosten für den Stromwandler gesenkt werden, indem eine Messschaltung des Kompensationsstromsensors nur bedarfsweise und möglicherweise erst später zusätzlich angeschafft wird.

Eine weitere Ausgestaltung der Erfindung sieht einen Stützisolator vor, auf dem das Gehäuse angeordnet ist. Diese Ausgestaltung der Erfindung ist insbesondere vorteilhaft, wenn an dem Primärleiter eine Hochspannung anliegt, um das Gehäuse und den Primärleiter in ausreichender Höhe und elektrisch isoliert von dem Boden anzuordnen.

Bei dem erfindungsgemäßen Verfahren zum Messen von Strömen mit einem erfindungsgemäßen Stromwandler wird mit dem induktiven Wechselstromsensor ein in dem Primärleiter fließender Wechselstrom oder ein Wechselstromanteil eines in dem Primärleiter fließenden Stroms erfasst und mit dem Kompensationsstromsensor wird ein in dem Primärleiter fließender Gleichstrom oder ein Gleichstromanteil eines in dem Primärleiter fließenden Stroms erfasst.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: schematisch ein Ausführungsbeispiel eines Stromwandlers,
- FIG 2: schematisch eine Schnittdarstellung eines Stromwandlerkopfes des in Figur 1 dargestellten Stromwandlers,
- FIG 3: schematisch den in Figur 1 dargestellten Stromwandler mit deaktiviertem Kompensationsstromsensor,
- FIG 4: schematisch ein nicht erfindungsgemäßes Ausführungsbeispiel eines Kompensationsstromsensors mit einem Hall-Sensor.

Einander entsprechende Teile sind in den Figuren mit denselben Bezugszeichen versehen.

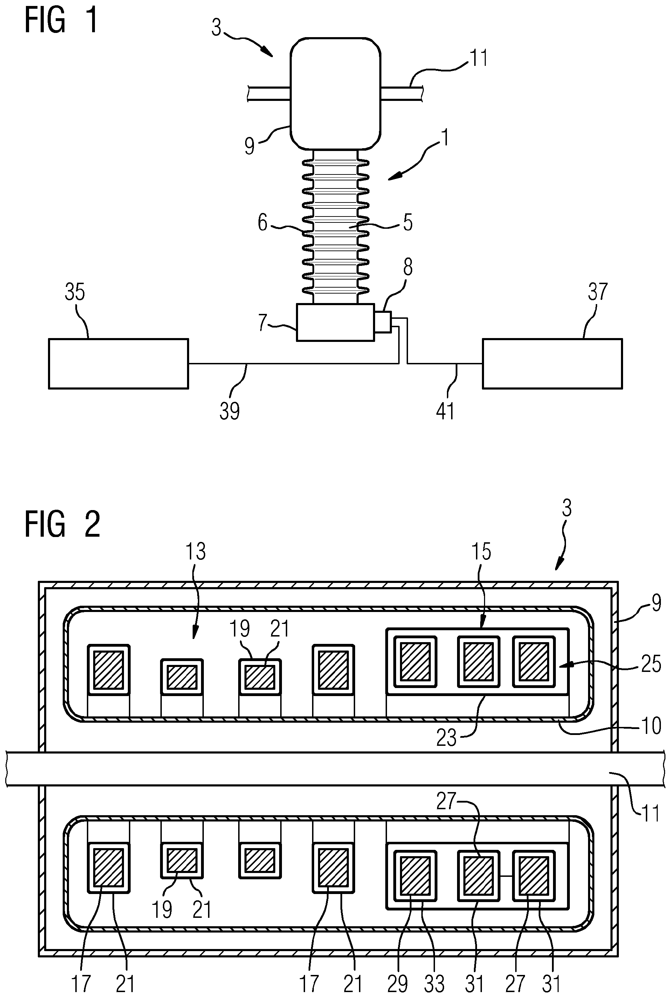

Figur 1 zeigt schematisch ein Ausführungsbeispiel eines Stromwandlers 1. Der Stromwandler 1 weist einen Stromwandlerkopf 3, einen Stützisolator 5, auf dem der Stromwandlerkopf 3 angeordnet ist, und einen Sockel 7, auf dem der Stützisolator 5 angeordnet ist und an dem ein Anschlusskasten 8 angeordnet ist, auf.

Figur 2 zeigt schematisch eine Schnittdarstellung des Stromwandlerkopfes 3. Der Stromwandlerkopf 3 weist ein Gehäuse 9 auf, durch das ein Primärleiter 11 geführt ist. In dem Gehäuse 9 ist ein torusartiges Wicklungsgehäuse 10 angeordnet, das um den Primärleiter 11 herum angeordnet ist.

Der Stromwandler 1 weist einen induktiven Wechselstromsensor 13 und einen Kompensationsstromsensor 15 auf.

Der induktive Wechselstromsensor 13 dieses Ausführungsbeispiels weist zwei ringförmige Schutzkerne 17 und zwei ringförmige Messkerne 19 auf, auf die jeweils eine Sekundärspule 21 gewickelt ist und die jeweils innerhalb des Wicklungsgehäuses 10 um den Primärleiter 11 herum verlaufen.

Der Kompensationsstromsensor 15 weist eine Kompensationsspule 23 und ein Magnometer 25 auf. Das Magnometer 25 ist als ein Fluxgate-Magnetometer ausgebildet und weist zwei weichmagnetische Kompensationskerne 27, einen weichmagnetischen Zusatzkern 29, eine Erregerwicklung 31 und eine Zusatzsekundärwicklung 33 auf. Die Kompensationskerne 27 und der Zusatzkern 29 sind jeweils ringförmig ausgebildet und verlaufen innerhalb des Wicklungsgehäuses 10 um den Primärleiter 11 herum. Die Erregerwicklung 31 ist gegensinnig um die beiden Kompensationskerne 27 gewickelt. Die Zusatzsekundärwicklung 33 ist um den Zusatzkern 29 gewickelt. Die Kompensationsspule 23 ist um die beiden Kompensationskerne 27 und den Zusatzkern 29 gewickelt. Im Betrieb des Kompensationsstromsensors 15 wird in der Erregerwicklung 31 ein Erregerwechselstrom erzeugt, der die Kompensationskerne 27 periodisch in die magnetische Sättigung treibt. Da die Erregerwicklung 31 gegensinnig um die beiden Kompensationskerne 27 gewickelt ist, sind die dabei erzeugten Magnetfelder der Kompensationskerne 27 einander entgegengerichtet. Die Kompensationskerne 27 und deren Umwicklungen durch die Erregerwicklung 31 sind bis auf die Wicklungsrichtungen gleich, so dass auch die Magnetfelder der Kompensationskerne 27 betragsmäßig gleich groß sind, wenn kein äußeres Magnetfeld auf die Kompensationskerne 27 einwirkt. Wenn jedoch ein äußeres Magnetfeld auf die Kompensationskerne 27 einwirkt, führt dieses zu voneinander verschiedenen Beträgen der Magnetfelder der Kompensationskerne 27, deren Differenz ein Maß für die Magnetfeldstärke des äußeren Magnetfeldes ist. Das auf die Kompensationskerne 27 einwirkende äußere Magnetfeld ist die Summe eines von einem Primärstrom in dem Primärleiter 11 erzeugten Primärmagnetfeldes und eines von einem Kompensationsstrom in der Kompensationsspule 23 erzeugten Kompensationsmagnetfeldes. Der Kompensationsstrom in der Kompensationsspule 23 wird so eingestellt, dass das Kompensationsmagnetfeld das Primärmagnetfeld in den Kompensationskernen 27 kompensiert beziehungsweise die Beträge der Magnetfelder der Kompensationskerne 27 gleich groß sind. Die Stromstärke des Kompensationsstroms ist daher ein Maß für die Stromstärke des Primärstroms und ermöglicht deren Messung. Die Kompensationskerne 27 dienen zur Messung in dem Primärleiter 11 fließender Gleichströme beziehungsweise Gleichstromanteile.

Der Zusatzkern 29 wird zur zusätzlichen Messung in dem Primärleiter 11 fließender Wechselströme beziehungsweise Wechselstromanteile verwendet, beispielsweise zur Messung von Wechselströmen beziehungsweise Wechselstromanteilen, für deren Messung die Messkerne 19 des induktiven Wechselstromsensors 13 nicht ausgelegt sind. Dabei werden durch den Kompensationsstrom in der Kompensationsspule 23 auch Primärmagnetfelder kompensiert, die in dem Zusatzkern 29 durch in dem Primärleiter 11 fließende Wechselströme beziehungsweise Wechselstromanteile erzeugt werden. Wechselstromanteile des Primärstroms und des Kompensationsstroms erzeugen Änderungen eines Magnetfeldes in dem Zusatzkern 29, die einen Sekundärstrom in der Zusatzsekundärwicklung 33 induziert. Der Wechselstromanteil des Kompensationsstroms wird daher so eingestellt, dass in der Zusatzsekundärwicklung 33 kein Sekundärstrom induziert wird.

Zur Erfassung in den Sekundärspulen 21 fließender Sekundärströme, die durch einen in dem Primärleiter 11 fließenden Wechelstrom oder Wechselstromanteil induziert werden, weist der induktive Wechselstromsensor 13 eine erste Messschaltung 35 auf. Zur Erzeugung des in der Erregerwicklung 31 fließenden Erregerstroms, Erzeugung und Einstellung des in der Kompensationsspule 23 fließenden Kompensationsstroms und optional zur Erfassung des in der Zusatzsekundärwicklung 33 fließenden Sekundärstroms weist der Kompensationsstromsensor 15 eine zweite Messschaltung 37 auf. Die erste Messschaltung 35 ist über erste Verbindungsleitungen 39 mit den Sekundärspulen 21 verbunden. Die zweite Messschaltung 37 ist über zweite Verbindungsleitungen 41 mit der Erregerwicklung 31 und der Kompensationsspule 23 sowie mit der Zusatzsekundärwicklung 33 verbunden. Die Verbindungsleitungen 39, 41 sind aus dem Wicklungsgehäuse 10 und dem Gehäuse 9 heraus und durch den Stützisolator 5 zu dem Anschlusskasten 8 und von dort zu den Messschaltungen 35, 37 geführt. Der Kompensationsstromsensor 15 ist deaktivierbar. Dazu sind die Teile der zweiten Verbindungsleitungen 41, die den Anschlusskasten 8 mit der zweiten Messschaltung 37 verbinden, lösbar, beispielsweise über eine Steckerverbindung, mit dem Anschlusskasten 8 verbunden. Nach dem Lösen dieser Teile der zweiten Verbindungsleitungen 41 von dem Anschlusskasten 8 sind die Erregerwicklung 31, die Zusatzsekundärwicklung 33 und die Kompensationsspule 23 jeweils kurzschließbar, beispielsweise mit einem Kurzschlusstecker 43, der anstelle dieser Teile der zweiten Verbindungsleitungen 41 mit dem Anschlusskasten 8 verbindbar ist.

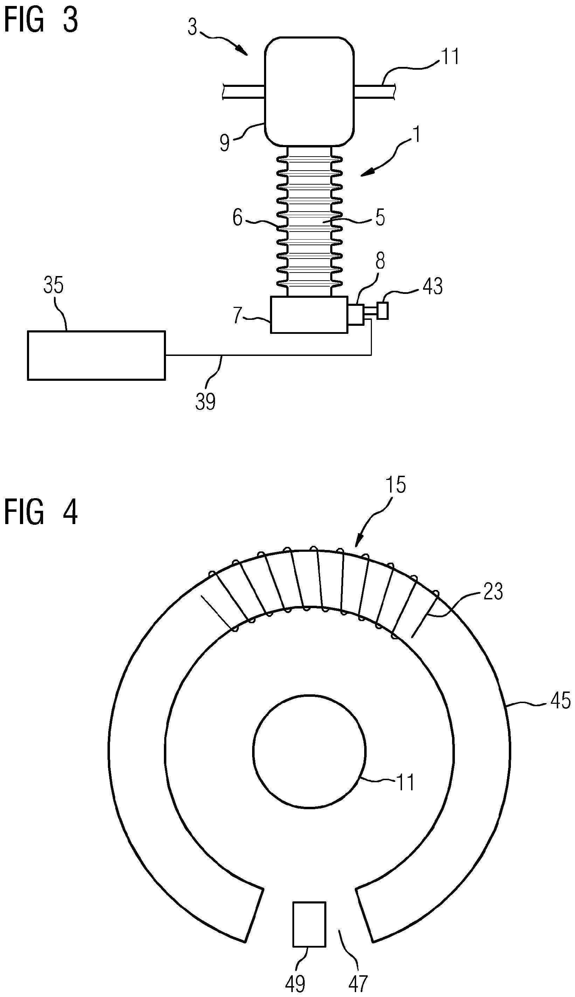

Figur 3 zeigt den Stromwandler 1 mit einem Kurzschlussstecker 43, der die Erregerwicklung 31, die Zusatzsekundärwicklung 33 und die Kompensationsspule 23 jeweils kurzschließt.

Der Stützisolator 5 ist als ein Hohlisolator ausgebildet und weist mehrere Isolierschirme 6 auf, die jeweils ringförmig um eine Längsachse des Stützisolators 5 verlaufen. Der Stützisolator 5 ist beispielsweise aus einem keramischen Werkstoff gefertigt oder als ein Rohr aus einem glasfaserverstärkten Kunststoff ausgebildet, an dem Isolierschirme 6 aus einem Silikon angeordnet sind.

Das Wicklungsgehäuse 10 ist gegenüber dem Gehäuse 9 elektrisch isoliert. Beispielsweise ist das Gehäuse 9 zu diesem Zweck mit einem Isoliergas, beispielsweise mit Schwefelhexafluorid oder Stickstoff, oder mit einer Isolierflüssigkeit, beispielsweise mit einem Isolieröl, oder einer Isoliermasse, beispielsweise einer Silikon-Isoliermasse, befüllt.

Das in den Figuren gezeigte Ausführungsbeispiel kann auf verschiedene nicht erfindungsgemäße Weise abgewandelt werden. Beispielsweise kann der induktive Wechselstromsensor 13 eine von Zwei verschiedene Anzahl von Schutzkernen 17 und/oder Messkernen 19 aufweisen. Insbesondere kann er gar keinen Schutzkern 17 oder gar keinen Messkern 19 aufweisen. Ferner kann der Kompensationsstromsensor 15 ein anderes Magnometer 25 als ein Fluxgate-Magnetometer aufweisen, beispielsweise ein Magnometer 25 mit einem Hall-Sensor 49 (siehe Figur 4).

Figur 4 zeigt schematisch ein nicht erfindungsgemäßes Ausführungsbeispiel eines Kompensationsstromsensors 15, der einen in dem Wicklungsgehäuse 10 angeordneten, ringförmig um den Primärleiter 11 verlaufenden Magnetkern 45 aufweist, um den die Kompensationsspule 23 gewickelt ist und der einen Luftspalt 47 aufweist, in dem ein Hall-Sensor 49 angeordnet ist. Mit dem Hall-Sensor 49 wird die Summe des von dem Primärleiter 11 erzeugten Primärmagnetfeldes und des von der Kompensationsspule 23 erzeugten Kompensationsmagnetfeldes am Ort des Hall-Sensors 49 erfasst und der in der Kompensationsspule 23 fließende Kompensationsstrom wird so eingestellt, dass diese Summe verschwindet.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Ansprüche zu verlassen.

## Patentansprüche

1. Stromwandler (1) zur Überwachung von Hoch- und Mittelspannungsnetzen mit Gleich- und Wechselströmen beziehungsweise Mischströmen, umfassend
- einen Primärleiter (11),
- ein Gehäuse (9), durch das der Primärleiter (11) geführt ist,
- einen induktiven Wechselstromsensor (13) mit wenigstens einer in dem Gehäuse (9) angeordneten Sekundärspule (21) und
- einen Kompensationsstromsensor (15) mit einer in dem Gehäuse (9) angeordneten Kompensationsspule (23) zur Erzeugung eines Kompensationsmagnetfeldes, das ein von dem Primärleiter (11) erzeugtes Primärmagnetfeld kompensiert, und einem Magnetometer (25) zur Erfassung einer Summe des Primärmagnetfeldes und des Kompensationsmagnetfeldes,
- wobei der induktive Wechselstromsensor (13) wenigstens einen Messkern (19) und wenigstens einen Schutzkern (17) aufweist,
- wobei das Magnetometer (25) ein Fluxgate-Magnetometer ist,
- wobei das Fluxgate-Magnetometer zwei in dem Gehäuse (9) angeordnete, ringförmig um den Primärleiter (11) verlaufende Kompensationskerne (27) und eine gegensinnig um die beiden Kompensationskerne (27) gewickelte Erregerwicklung (31) aufweist, und
- wobei das Fluxgate-Magnetometer einen in dem Gehäuse (9) angeordneten, ringförmig um den Primärleiter (11) verlaufenden Zusatzkern (29) und eine Zusatzsekundärwicklung (33) aufweist und die Zusatzsekundärwicklung (33) und die Kompensationsspule (23) um den Zusatzkern (29) gewickelt sind.

2. Stromwandler (1) nach Anspruch 1,
**gekennzeichnet durch**
ein in dem Gehäuse (9) angeordnetes Wicklungsgehäuse (10), in dem die wenigstens eine Sekundärspule (21) und die Kompensationsspule (23) angeordnet sind.

3. Stromwandler (1) nach Anspruch 2,
**dadurch gekennzeichnet, dass**
das Wicklungsgehäuse (10) gegenüber dem Gehäuse (9) elektrisch isoliert ist.

4. Stromwandler (1) nach einem der vorhergehenden Ansprüche, **dadurch gekennzeichnet, dass** das Gehäuse (9) mit einem Isoliergas oder einer Isolierflüssigkeit oder einer Isoliermasse befüllt ist.

5. Stromwandler (1) nach einem der vorhergehenden Ansprüche,
**dadurch gekennzeichnet, dass**
der induktive Wechselstromsensor (13) eine erste Messschaltung (35) aufweist, die außerhalb des Gehäuses (9) angeordnet ist und mit jeder Sekundärspule (21) elektrisch verbunden ist.

6. Stromwandler (1) nach einem der vorhergehenden Ansprüche,
**dadurch gekennzeichnet, dass**
der Kompensationsstromsensor (15) eine zweite Messschaltung (37) aufweist, die außerhalb des Gehäuses (9) angeordnet ist und mit der Kompensationsspule (23) und dem Magnetometer (25) elektrisch verbunden ist.

7. Stromwandler (1) nach einem der vorhergehenden Ansprüche,
**dadurch gekennzeichnet, dass**
der Kompensationsstromsensor (15) deaktivierbar ist.

8. Stromwandler (1) nach einem der vorhergehenden Ansprüche,
**gekennzeichnet durch**
einen Stützisolator (5), auf dem das Gehäuse (9) angeordnet ist.

9. Verfahren zum Messen von Strömen mit einem gemäß einem der vorhergehenden Ansprüche ausgebildeten Stromwandler (1), wobei
- mit dem induktiven Wechselstromsensor (13) ein in dem Primärleiter (11) fließender Wechselstrom oder ein Wechselstromanteil eines in dem Primärleiter (11) fließenden Stroms erfasst wird und
- mit dem Kompensationsstromsensor (15) ein in dem Primärleiter (11) fließender Gleichstrom oder ein Gleichstromanteil eines in dem Primärleiter (11) fließenden Stroms erfasst wird.

## Claims

1. Current converter (1) for monitoring of high- and medium-voltage grids having direct and alternating currents or mixed currents, comprising:
- a primary conductor (11);
- a housing (9) through which the primary conductor (11) is led;
- an inductive alternating current sensor (13) having at least one secondary coil (21) which is disposed in the housing (9) and
- a compensation current sensor (15) having a compensation coil (23) disposed in the housing (9) for producing a compensation magnetic field, compensating a primary magnetic field produced by the primary conductor (11), and a magnetometer (25) for sensing a sum of the primary magnetic field and the compensation magnetic field,
- wherein the inductive alternating current sensor (13) has at least one measuring core (19) and at least one protective core (17),
- wherein the magnetometer (25) is a fluxgate magnetometer,
- wherein the fluxgate magnetometer has two compensation cores (27) arranged in the housing (9), annularly extending about the primary conductor (11), and an excitation winding (31) wound in an inverse direction about the two compensation cores (27), and
- wherein the fluxgate magnetometer has an additional core (29) and an additional secondary winding (33) arranged in the housing (9), annularly extending about the primary conductor (11) and the additional secondary winding (33) and the compensation coil (23) are wound about the additional core (29).

2. The current converter (1) according to claim 1, **characterized in that** a winding housing (10) is arranged in the housing (9), in which the at least one secondary coil (21) and the compensation coil (23) are arranged.

3. The current converter (1) according to claim 2, **characterized in that** the winding housing (10) is electrically insulated vis-à-vis the housing (9).

4. The current converter (1) according to one of the preceding claims, **characterized in that** the housing (9) is filled with an insulating gas or an insulating fluid, or an insulating compound.

5. The current converter (1) according to one of the preceding claims, **characterized in that** the inductive alternating current sensor (13) has a first measuring circuit (35), which is arranged outside the housing (9) and is electrically connected to each said secondary coil (21).

6. The current converter (1) according to one of the preceding claims, **characterized in that** the compensation current sensor (15) has a second measuring circuit (37), which is arranged outside the housing (9) and is electrically connected with the compensation coil (23) and the magnetometer (25).

7. The current converter (1) according to one of the preceding claims, **characterized in that** the compensation current sensor (15) is deactivable.

8. The current converter (1) according to one of the preceding claims, **characterized in that** the housing is arranged upon a post insulator (5).

9. Method for measuring currents with a current converter (1) according to one of the preceding claims, wherein
- with the inductive alternating current sensor (13) an alternating current flowing in the primary conductor (11) or an alternating current component of a current flowing in the primary conductor (11) is sensed and
- with the compensation current sensor (15) a direct current flowing in the primary conductor (11) or a direct current component of a current flowing in the primary conductor (11) is sensed.

## Revendications

1. Transformateur de courant (1) pour la surveillance de réseaux à haute et moyenne tension à courants continus et alternatifs ou à courants mixtes, comprenant
- un conducteur primaire (11),
- un boîtier (9) à travers lequel passe le conducteur primaire (11),
- un capteur inductif de courant alternatif (13) ayant au moins une bobine secondaire (21) agencée dans le boîtier (9) et
- un capteur de courant de compensation (15) ayant une bobine de compensation (23) agencée dans le boîtier (9) et destinée à générer un champ magnétique de compensation, qui compense un champ magnétique primaire généré par le conducteur primaire (11), et un magnétomètre (25) destiné à détecter une somme du champ magnétique primaire et du champ magnétique de compensation,
- le capteur inductif de courant alternatif (13) comportant au moins un noyau de mesure (19) et au moins un noyau de protection (17),
- le magnétomètre (25) étant un magnétomètre de type fluxgate,
- le magnétomètre de type fluxgate présentant deux noyaux de compensation (27) agencés dans le boîtier (9) et s'étendant en forme d'anneau autour du conducteur primaire (11), et un enroulement d'excitation (31) enroulé en sens inverse autour des deux noyaux de compensation (27), et
- le magnétomètre de type fluxgate présentant un noyau supplémentaire (29) agencé dans le boîtier (9) et s'étendant en forme d'anneau autour du conducteur primaire (11), et un enroulement secondaire supplémentaire (33), et l'enroulement secondaire supplémentaire (33) et la bobine de compensation (23) étant enroulés autour du noyau supplémentaire (29).

2. Transformateur de courant (1) selon la revendication 1,
**caractérisé par**
un boîtier d'enroulement (10) agencé dans le boîtier (9), dans lequel sont agencées ladite au moins une bobine secondaire (21) et la bobine de compensation (23).

3. Transformateur de courant (1) selon la revendication 2,
**caractérisé en ce que**
le boîtier d'enroulement (10) est isolé électriquement par rapport au boîtier (9).

4. Transformateur de courant (1) selon l'une des revendications précédentes, **caractérisé en ce que** le boîtier (9) est rempli d'un gaz ou d'un liquide isolant ou d'une masse isolante.

5. Transformateur de courant (1) selon l'une des revendications précédentes, **caractérisé en ce que**
le capteur inductif de courant alternatif (13) comprend un premier circuit de mesure (35) agencé à l'extérieur du boîtier (9) et relié électriquement à chaque bobine secondaire (21).

6. Transformateur de courant (1) selon l'une des revendications précédentes, **caractérisé en ce que**
le capteur de courant de compensation (15) comprend un deuxième circuit de mesure (37) agencé à l'extérieur du boîtier (9) et relié électriquement à la bobine de compensation (23) et au magnétomètre.

7. Transformateur de courant (1) selon l'une des revendications précédentes, **caractérisé en ce que**
le capteur de courant de compensation (15) est apte à être désactivé.

8. Transformateur de courant (1) selon l'une des revendications précédentes, **caractérisé par**
un isolateur de support (5) sur lequel est agencé le boîtier (9).

9. Procédé de mesure de courants avec un transformateur de courant (1) conçu selon l'une des revendications précédentes,
dans lequel
- un courant alternatif circulant dans le conducteur primaire (11) ou une composante de courant alternatif d'un courant circulant dans le conducteur primaire (11) est détecté au moyen du capteur de courant alternatif inductif (13), et
- un courant continu circulant dans le conducteur primaire (11) ou une composante de courant continu d'un courant continu circulant dans le conducteur primaire (11) est détecté au moyen du capteur de courant de compensation (15).
